# EUROPEAN PATENT APPLICATION

(11) **EP 4 851 570 A1**
(43) Date of publication of application: **09.12.2026**
(21) Application number: 26175235.6
(22) Date of filing: 28.04.2026
(51) Int. Cl.: F28D 15/04, F28F 27/00, H05K 7/20, H10W 40/73, F28D 21/00

(54) **USE OF IMPACT ABSORBENT MATERIALS IN THERMAL STACKS**

(30) Priority: 05.06.2025 US 202519229358
(71) Applicant: GE Aviation Systems Limited, Bishops Cleeve Cheltenham Gloucestershire GL52 8SF (GB)
(72) Inventor: SMITH, Michael James, Cheltenham, GL52 8SF (GB); LEIVERS, Christopher, Cheltenham, GL52 8SF (GB); CORDERO-MARTINEZ, Jesus Salvador, Cheltenham, GL52 8SF (GB); PEREIRA, Frazer, Cheltenham, GL52 8SF (GB)
(74) Representative: Openshaw & Co.

(57) **Abstract**

Disclosed are various examples for providing ballistic protection in a thermal stack (100a-f). Such a thermal stack (100a-f) may comprise a vapor chamber (106a-d) or thermal interface material (173) positioned within the thermal stack (100a-f) that includes a heat generating component (103). A heat sink (109) may be positioned adjacent to the vapor chamber (106a-d) or thermal interface material (173). An impact absorbent material (133a-f) positioned within the thermal stack (100a-f) to provide protection against arcing or other events in the thermal stack (100a-f).

## Description

### BACKGROUND

Component failures and arcing events have the potential to damage systems and products. At times, such arcing events can result in breakage of components that are ejected at significant velocity. Such ejected components can result in significant damage to systems.

### BRIEF DESCRIPTION OF THE DRAWINGS

Many aspects of the present disclosure can be better understood with reference to the following drawings. The components in the drawings are not necessarily to scale, with emphasis instead being placed upon clearly illustrating the principles of the disclosure. Moreover, in the drawings, like reference numerals designate corresponding parts throughout the several views.
FIG. 1A is a drawing of a thermal stack that employs an impact absorbent material in a vapor chamber according to an example of the present disclosure.
FIG. 1B is a drawing of a portion of a woven fabric employed as the impact absorbent material according to an example of the present disclosure.
FIG. 2A is a drawing of a thermal stack that employs an impact absorbent material in a C-shaped vapor chamber according to an example of the present disclosure.
FIG. 2B is a drawing of a thermal stack that employs an impact absorbent material in a I-shaped vapor chamber according to an example of the present disclosure.
FIG. 3 is a drawing of a thermal stack that employs an impact absorbent material between two vapor chambers according to an example of the present disclosure.
FIG. 4 is a drawing of a thermal stack that employs offset impact absorbent materials in a vapor chamber according to an example of the present disclosure.
FIG. 5 is a drawing of a thermal stack that employs impact absorbent materials within a thermal interface material according to an example of the present disclosure.
FIG. 6 is a drawing of a thermal stack that employs impact absorbent materials within a heat generating component according to an example of the present disclosure.
FIG. 7 is a drawing of an interwoven fabric made from impact absorbent material and other materials according to an example of the present disclosure.
FIG. 8 is a flowchart of a method in accordance with an example of the present disclosure.

### DETAILED DESCRIPTION

Many electrical components and physical components generate heat that can be detrimental to their operation. In such cases, various strategies can be employed to dissipate the heat generated by such heat generating components into the environment surrounding the components or to cool the components during operation.

Heat generating components, for example, can experience arcing events or other failures. Such arcing events can be violent in some extreme cases and result in the ejection of debris that can potentially damage nearby systems causing further failure. For example, if such heat generating components comprise electrical components such as electrical circuits or integrated circuits, arcing events can occur due to electrical shorts or other issues. If such components are used in certain environments such as on an aircraft or within components thereof, the ejection of debris that potentially can damage other systems can be of greater consequence. In the following discussion, various examples of thermal stacks are described in which impact absorbent materials are used to contain the ejection of debris due to arcing events and other failure events.

It should be noted that like numbers that appear from one figure to the next designate corresponding parts throughout the several views. Where items are designed with letters such as "a," "b," "c," "d," "e," "f," "aa," "ab," "ba," "bb," "ca," or "cb," such designations indicate different examples of corresponding parts in different contexts.

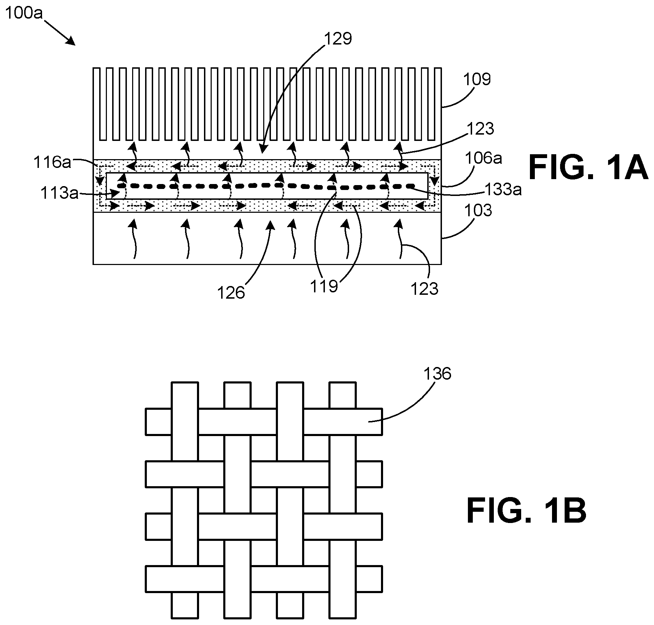

With reference to FIG. 1A, shown is an example of a thermal stack 100a that includes a heat generating component 103, a vapor chamber 106a, and a heat sink 109.

The heat generating component 103 may comprise any electronic, electromechanical, chemical, or other heat producing component. Heat may be generated by way of electrical conduction, mechanical friction, chemical reaction, or in some other manner. For example, the heat generating component 103 may comprise an integrated circuit such as a processor circuit or other circuit. Also, the heat generating component 103 may be an electromechanical system that generates heat during operation. Such heat generating components 103 may be used in an aircraft or in other similar applications. For example, various circuitry including integrated circuits such as microprocessors may be employed for many purposes within an aircraft such as control, system operation, and other purposes.

The vapor chamber 106a is positioned within the thermal stack 100a that includes the heat generating component 103. In one example, a surface of the vapor chamber 106a may be in contact with a surface of the heat generating component 103. A thermal interface material such as a thermal gel or thermal grease may be employed to ensure good thermal contact between the heat generating component 103 and the vapor chamber 106a. Alternatively, the vapor chamber 106a may be positioned at some other location within the thermal stack 100a.

The vapor chamber 106a may comprise a conformal vapor chamber, a heat pipe, or potentially some other type of vapor chamber device that is used to conduct heat away from a heat generating component. A vapor chamber 106a comprises a two phase device that efficiently spreads heat and improves heat dissipation in a variety of applications.

The heat sink 109 may comprise a structure that facilitates the transfer of heat from a thermal stack to another fluid medium such as, for example, air or liquid coolant. The heat sink 109 may employ fins, pins, holes in elements, geometric structures, or other structures that maximize heat transfer surfaces to allow for maximum heat transfer into a fluid medium surrounding the heat sink 109. The heat sink 109 may be positioned adjacent to the vapor chamber 106a. As contemplated herein, a first component may be adjacent to a second component even if a third component is included between the first and second components.

The vapor chamber 106a includes an internal chamber 113a and a wicking structure 116a. The vapor chamber 106a includes an amount of working fluid 119 such as water or other medium that facilitates the transfer of heat 123 from a hot side 126 to a cold side 129 of the vapor chamber 106a. The internal chamber 113a may include cross members (not shown) to hold the respective sides apart given a partial vacuum is created in the internal chamber 113a.

An impact absorbent material 133a is positioned within the thermal stack 100a. In the example shown in FIG. 1A, the impact absorbent material 133a is positioned inside the internal chamber 113a. The impact absorbent material 133a may be, for example, any material that is designed to intercept and absorb the impact of ejected debris such that the ejected debris is contained or otherwise prevented from contacting or damaging nearby systems.

With reference to FIG. 1B, in one example, the impact absorbent material 133a may comprise a woven fabric 136 constructed from Kevlar^{™} or other material. Kevlar^{™} is a trademark of E. I. du Pont de Nemours and Company of Wilmington, Delaware. The impact absorbent material 133a may also be a polyethylene based material or other types of materials. It should be noted that the items listed herein as item 133 are constructed in the same or similar manner as set forth above with respect to the impact absorbent material 133a.

Referring back to FIG. 1A, when heat 123 is generated by the heat generating component 103, it moves by way of convection to the hot side 126 of the vapor chamber 106a. Working fluid 119 that is in the wicking structure 116a near the hot side 126 of the vapor chamber 106a is converted to vapor that leaves the wicking structure 116a and enters the internal chamber 113a of the vapor chamber 106a. The working fluid 119 in vapor form then moves to a point of lower pressure near the cold side 129 of the vapor chamber 106a where it condenses back into a liquid form. The wicking structure 116a then facilitates the flow of the working fluid 119 back to the hot side 126 by way of capillary action where the cycle is repeated.

As the working fluid 119 in vapor form migrates across the internal chamber 113a, some or all of the working fluid 119 passes through the impact absorbent material 133a. To facilitate the movement of the working fluid 119 in vapor form through the impact absorbent material 133a, the impact absorbent material 133a may be constructed in a woven fabric 136 (FIG. 1B) with a weave that includes small holes or pathways that allow the vapor to pass therethrough. In this respect, the impact absorbent material 133a is constructed in a manner so that the resulting woven fabric 136 or other structure is permeable to allow the vapor to pass through.

By virtue of the position of the impact absorbent material 133a, any debris that might be launched by an arcing event or other failure in the heat generating component 103 can be contained by the impact absorbent material 133a. Arcing may occur, for example, due to a short in an electrical system. Alternatively, an arcing event may occur due to power surges or transients that may occur in a given system. Other failures may comprise electrical systems that undergo physical impact or vibration, or other problems. Specifically, given the position of the impact absorbent material 133a relative to the heat generating component 103, the kinetic energy of such debris is absorbed. This prevents a failure in a single component from potentially damaging other components in an overall system. In systems that have redundancy in terms of physical components, the addition of the impact absorbent material 133a to the thermal stack 100a ensures that other components that are redundant to the heat generating component 103 are shielded in the event of a failure in the heat generating component 103 so that overall functionality is retained. This results in safer and more reliable systems.

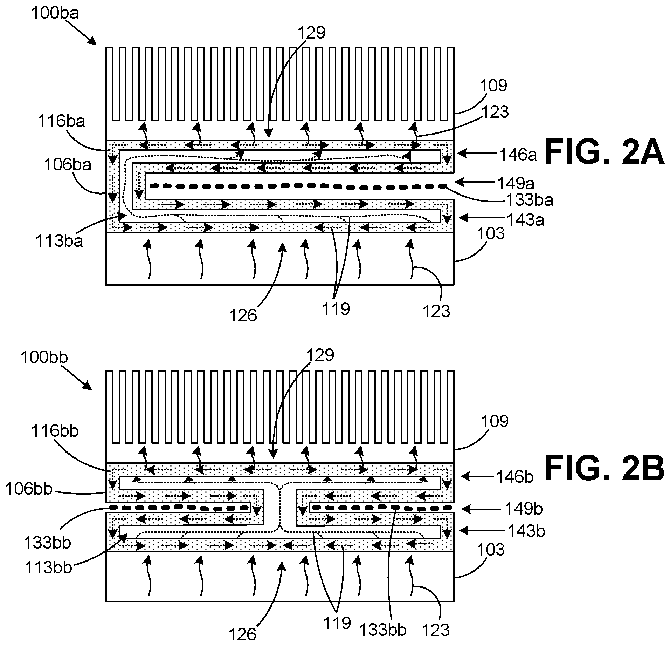

With reference to FIG. 2A, shown is a thermal stack 100ba according to an example of the present disclosure. The thermal stack 100ba includes the heat generating component 103, a vapor chamber 106ba, and a heat sink 109. The heat generating component 103 and the heat sink 109 are essentially the same or similar to corresponding components as described herein with respect to FIG. 1A.

The vapor chamber 106ba includes a hot side 126 and a cold side 129 in a similar manner to the vapor chamber 106a (FIG. 1A) as discussed above. However, the vapor chamber 106ba has a C-shaped cross section as shown. In this respect, the vapor chamber 106ba includes a first portion 143a that correlates to the hot side 126 and a second portion 146a that correlates to the cold side 129. The vapor chamber 106ba is continuous from the first portion 143a to the second portion 146a. Also, the vapor chamber 106ba includes a wicking structure 116ba that follows the internal walls of the vapor chamber 106ba. Due to the C-shaped cross section, the vapor chamber 106ba defines a gap 149a between the first portion 143a and the second portion 146a of the vapor chamber 106ba. The gap 149a is open to an external environment adjacent to the thermal stack 100ba. The impact absorbent material 133ba is positioned within the gap 149a as shown. Specifically, the impact absorbent material 133ba may be pushed or slid into the gap 149a. In accordance with the present disclosure, the impact absorbent material 133ba is the same as or similar to the impact absorbent material 133a (FIG. 1A).

When heat 123 is generated by the heat generating component 103, the heat 123 moves by way of convection to the hot side 126 of the vapor chamber 106ba. Working fluid 119 that is in the wicking structure 116ba near the hot side 126 of the vapor chamber 106ba is converted to vapor that leaves the wicking structure 116ba and enters the internal chamber 113ba of the vapor chamber 106ba. The working fluid 119 in vapor form moves to a point of lower pressure near the cold side 129 of the vapor chamber 106ba where it condenses into a liquid form. The wicking structure 116ba then facilitates the flow of the working fluid 119 to the hot side 126 by way of capillary action where the cycle is repeated. Note that the wicking structure 116ba directs the flow of the working fluid 119 along the walls of the C-shaped vapor chamber 106ba. In this respect, the working fluid 119 flows from the second portion 146b to the first portion 143b given the C-shaped configuration.

Since the impact absorbent material 133ba is positioned in the gap 149a, the working fluid 119 in vapor form does not have to flow through the impact resistant material 133ba as opposed to the situation where the impact absorbent material 133a (FIG. 1A) is positioned in the vapor chamber 106a (FIG. 1A). By virtue of the position of the impact absorbent material 133ba, debris that might be launched by an arcing event or other failure in the heat generating component 103 can be contained by the impact absorbent material 133ba in a manner similar to the impact absorbent material 133a (FIG. 1) described above.

Referring next to FIG. 2B, shown is a thermal stack 100bb according to an example of the present disclosure. The thermal stack 100bb includes the heat generating component 103, a vapor chamber 106bb, and a heat sink 109. The heat generating component 103 and the heat sink 109 are the same or similar to corresponding components described herein with respect to FIG. 1A.

Similar to the vapor chamber 106ba (FIG. 2A), the vapor chamber 106bb includes a hot side 126 and a cold side 129 in a similar manner to the vapor chamber 106a (FIG. 1A) as discussed above. However, the vapor chamber 106bb has an I-shaped cross section as shown. In this respect, the vapor chamber 106bb includes a first portion 143b that correlates to the hot side 126 and a second portion 146b that correlates to the cold side 129. The vapor chamber 106bb is continuous from the first portion 143b to the second portion 146b, where the first and second portions 143b and 146b are linked in the middle of the vapor chamber 106bb.

The vapor chamber 106bb includes a wicking structure 116bb that follows the internal walls of the vapor chamber 106bb. Due to the I-shaped cross section, a gap 149b exists between the first portion 143b and the second portion 146b of the vapor chamber 106bb. The gap 149b is open to an external environment around the thermal stack 100bb.

The impact absorbent material 133bb is positioned in the gap 149b. To accommodate the center portion that links the first and second portions 143b and 146b, the impact absorbent material 133bb includes a hole in the center. The impact absorbent material 133bb may also include a cut from the exterior to the hole so that the impact absorbent material 133bb may be placed within the gap 149b. In accordance with the present disclosure, the impact absorbent material 133bb is the same as or similar to the impact absorbent material 133a (FIG. 1A).

The operation of the vapor chamber 106bb is similar to the operation of vapor chamber 106ba. When heat 123 is generated by the heat generating component 103, it moves by way of convection to the hot side 126 of the vapor chamber 106bb. Working fluid 119 that is in the wicking structure 116bb near the hot side 126 of the vapor chamber 106bb is converted to vapor that leaves the wicking structure 116bb and enters the internal chamber 113bb of the vapor chamber 106bb. The working fluid 119 in vapor form then moves to a point of lower pressure near the cold side 129 of the vapor chamber 106bb where it condenses back into a liquid form. The wicking structure 116bb then facilitates the flow of the working fluid 119 back to the hot side 126 by way of capillary action where the cycle is repeated. Note that the wicking structure 116bb directs the flow of the working fluid 119 along the walls of the I-shaped vapor chamber 106bb as shown.

Since the impact absorbent material 133bb is positioned in the gap 149b, the working fluid 119 in vapor form does not have to flow through the impact resistant material 133ba as opposed to the situation where the impact absorbent material 133a (FIG. 1A) is positioned in the vapor chamber 106a (FIG. 1A). By virtue of the position of the impact absorbent material 133bb, debris that might be launched by an arcing event or other failure in the heat generating component 103 can be contained by the impact absorbent material 133bb in a manner similar to the impact absorbent material 133ba (FIG. 2A) described above.

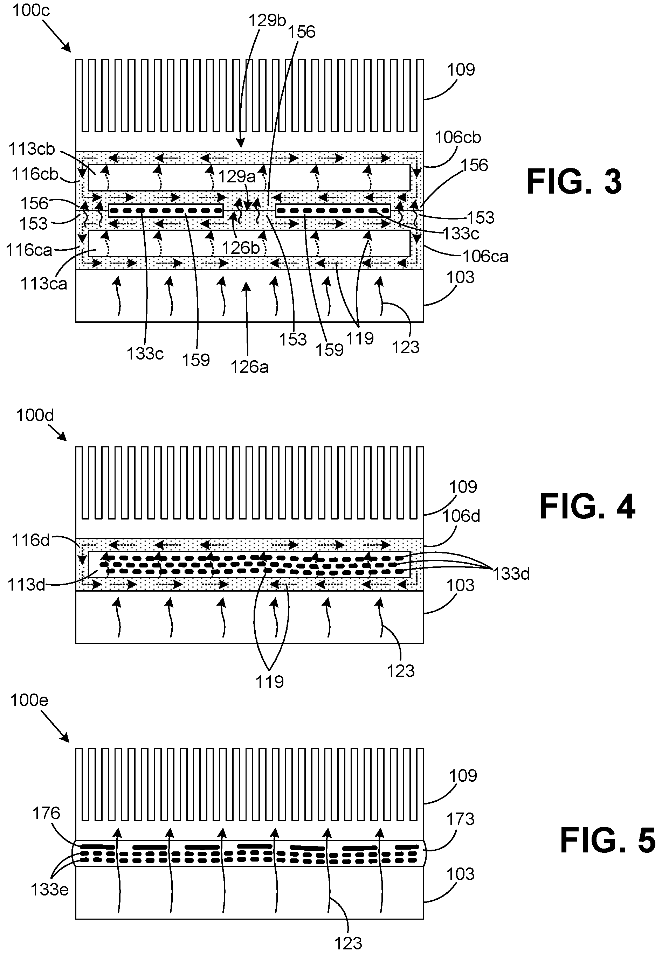

Referring next to FIG. 3, shown is a thermal stack 100c according to an example of the present disclosure. The thermal stack 100c includes the heat generating component 103, a first vapor chamber 106ca, a second vapor chamber 106cb, and a heat sink 109. The heat generating component 103 and the heat sink 109 are essentially the same or similar to the corresponding components described herein with respect to FIG. 1A.

The first vapor chamber 106ca includes a hot side 126a and a cold side 129a in a similar manner to the vapor chamber 106a (FIG. 1A) as discussed above. The second vapor chamber 106cb also includes a hot side 126b and a cold side 129b. Both the first vapor chamber 106ca and the second vapor chamber 106cb include a respective wicking structure 116ca and 116cb as shown. The first and second vapor chambers 106ca and 106cb include internal chambers 113ca and 11 3cb.

The first and second vapor chambers 106ca and 106cb are positioned adjacent to each other. In one example, at least a portion of the cold side 129a of the first vapor chamber 106ca is in contact with a portion of the hot side 126b of the second vapor chamber 106cb. To enhance heat transfer between portions of the cold side 129a and the hot side 126b that come into contact with each other, a thermal grease, thermal gel, thermal pad or other thermal conduction enhancer may be disposed between the points of contact.

The cold side 129a of the first vapor chamber 106ca includes one or more raised portions 153. In one example, the raised portions 153 come into contact with a flat version of the hot side 126b. In another example, the hot side 126b of the second vapor chamber 106cb may include raised portions 156 that come into contact with a flat version of the cold side 129a. In still another example, both the cold side 129a of the first vapor chamber 106ca and the hot side 126b of the second vapor chamber 106cb may include raised portions 153 and 156. In such case, the raised portions 153 and 156 would coincide with each other and come into contact with each other.

Regardless of the specific configuration employed, the raised portions 153 or 156, either singularly or together, at least partly define a pocket 159 between first and second vapor chambers 106ca and 106cb. There may be one or more pockets 159 between the first and second vapor chambers 106ca and 106cb. Also, in one example, one or more of the pockets 159 may be open to the environment surrounding the thermal stack 100c.

In one example, the impact absorbent material 133c is positioned between first and second vapor chambers 106ca and 106cb. In this respect, the impact absorbent material 133c is positioned in the pockets 159. In addition, an amount of thermal grease or gel may be included in the pockets 159 and the impact absorbent material 133 may be "wetted through" with such grease or gel to enhance heat transfer between the first and second vapor chambers 106ca and 106cb. In accordance with the present disclosure, the impact absorbent material 133c is the same as or similar to the impact absorbent material 133a (FIG. 1A).

The operation of the first and second vapor chambers 106ca and 106cb is similar to the operation of vapor chamber 106a (FIG. 1A). When heat 123 is generated by the heat generating component 103, it moves by way of convection to the hot side 126a of the first vapor chamber 106ca. Working fluid 119 that is in the wicking structure 116ca near the hot side 126a is converted to vapor that leaves the wicking structure 116ca and enters the internal chamber 113ca of the first vapor chamber 106ca. The working fluid 119 in vapor form then moves to a point of lower pressure near the cold side 129a of the first vapor chamber 106ca where it condenses back into a liquid form. The wicking structure 116ca then facilitates the flow of the working fluid 119 back to the hot side 126a by way of capillary action where the cycle is repeated. Note that the wicking structure 116ca directs the flow of the working fluid 119 along the walls of the first vapor chamber 106ca as shown.

Heat 123 then leaves the cold side 129a of the first vapor chamber 106ca and enters the hot side 126b of the second vapor chamber 106cb where the cycle is repeated and the heat 123 moves from the second vapor chamber 106cb to the heat sink 109 and then to the environment around the thermal stack 100c.

To the extent that the impact absorbent material 133c is positioned in the one or more pockets 159, the impact absorbent material 133c can contain or intercept debris that might be launched by an arcing event or other failure in the heat generating component 103 in a manner similar as was described with reference to the impact absorbent material 133a (FIG. 1A) described above. It should be noted that the pockets 159 may vary in size, which in turn means that the size of the impact absorbent material 133c may vary accordingly. As such, there is a tradeoff between the size of the pockets 159 and the potential impact on heat transfer.

Referring next to FIG. 4, shown is a thermal stack 100d according to an example of the present disclosure. The thermal stack 100d includes the heat generating component 103, a vapor chamber 106d, and a heat sink 109. The heat generating component 103 and the heat sink 109 are essentially the same as or similar to corresponding components described herein with respect to FIG. 1A.

The vapor chamber 106d is essentially the same as or similar to the vapor chamber 106a (FIG. 1A). The vapor chamber 106d includes an internal chamber 113d surrounded by a wicking structure 116d as shown. In the example of FIG. 4, multiple different instances of impact absorbent material 133d are positioned within the internal chamber 113d, where the working fluid 119 in vapor form flows through holes and/or passageways through the impact absorbent material 133d. In one example, each instance of the impact absorbent material 133d comprises a sheet of woven fabric 136 (FIG. 1B) constructed from Kevlar^{™} or other materials as was described above with respect to the impact absorbent material 133a (FIG. 1A).

In one example, such sheets of woven fabric 136 are offset with respect to each other. The particular weaves are offset such that any holes or passageways are misaligned in the direction of the flow of heat 123 through the thermal stack 100d.

By virtue of the placement of the multiple instances of the impact absorbent material 133d, the impact absorbent material 133d can contain or intercept any debris that might be launched by an arcing event or other failure in the heat generating component 103 in a manner similar as was described with reference to the impact absorbent material 133a (FIG. 1A) described above. In addition, where the impact absorbent material 133d comprises a sheet of woven fabric 136, the fact that such sheets are offset with respect to each other aids in ensuring that there are few holes or passageways that will allow debris from an arcing event or other failure to successfully travel through such sheets of woven fabric 136.

Referring next to FIG. 5, shown is a thermal stack 100e according to an example of the present disclosure. The thermal stack 100e includes the heat generating component 103, a thermal interface material 173, and a heat sink 109. The heat generating component 103 and the heat sink 109 are essentially the same or similar to corresponding components described with respect to FIG. 1A.

The heat sink 109 is positioned in in the thermal stack 100e that includes the heat generating component 103. In one example, the thermal interface material 173 is disposed between the heat sink 109 and the heat generating component 103. Impact absorbent material 133e is positioned within the thermal interface material 173. In addition, other materials 176 may be positioned within the thermal interface material 173.

The thermal interface material 173 may comprise a semi-solid such as a thermal gel or a thermal grease. Alternatively, the thermal interface material 173 may comprise a thermal gap filler pad, a dielectric pad, thermal tapes, phase change materials, or other materials. The thermal interface material 173 may be, for example, silicon based or other thermally conductive material.

In one example, the impact absorbent material 133e comprises woven fabric 136 (FIG. 1B) made of Kevlar^{™} or other material as described above. Where the thermal interface material 173 comprises a semi-solid such as thermal gel or thermal grease, the woven fabric 136 may be suspended in the semi-solid. In this respect, the impact absorbent material 133e comprising woven fabric 136 may be wetted through with semi-solid that makes up the thermal interface material 173 in order to enhance heat transfer through the layer of thermal interface material 173 and the impact absorbent material 133e.

In addition, where the thermal interface material 173 is embodied in the form of a thermal gap filler pad, a dielectric pad, thermal tapes, phase change materials, or other materials, the impact absorbent material 133e comprising a woven fabric 136 constructed from Kevlar^{™} or other material may be embedded in the thermal gap filler pad, dielectric pad, thermal tape, or phase change material.

There may be multiple instances of the impact absorbent material 133e embedded or suspended in a given thermal interface material 173. In one example, where the impact absorbent material 133e comprises a woven fabric 136, the position of different pieces of woven fabric 136 may be offset relative to each other so that holes or passageways do not align in a direction of the flow of heat 123.

The other materials 176 may comprise, for example, conductive materials that detect intrusion of debris launched due to an arcing event or other failure in the heat generating component 103. Alternatively, the other materials 176 may comprise a hybrid weave of impact absorbent material 133e and other materials as will be described.

Given the position of the impact absorbent material 133e in the thermal stack 100e, debris that might be launched by an arcing event or other failure in the heat generating component 103 can be contained by the impact absorbent material 133e. Specifically, given the position of the impact absorbent material 133e relative to the heat generating component 103, the kinetic energy of such debris is absorbed.

This prevents a failure in a single component from potentially doing physical harm to other components in an overall system. In systems that have significant redundancy in terms of physical components, the addition of the impact absorbent material 133e to the thermal stack 100e ensures that other components that are redundant to the heat generating component 103 are protected in spite of a failure in the heat generating component 103 so that overall functionality is retained. This results in safer and more reliable systems.

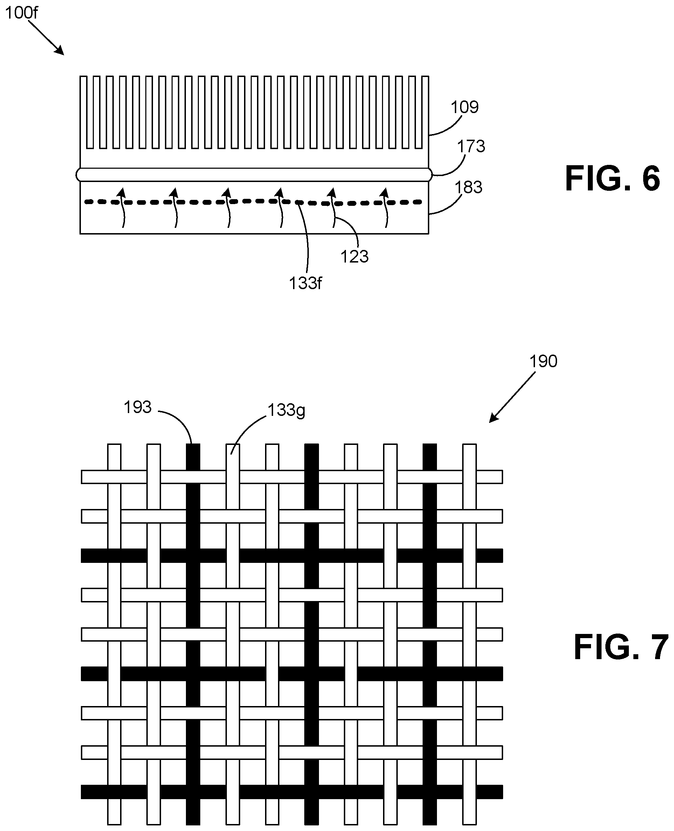

Referring to FIG. 6, shown is a thermal stack 100f according to an example of the present disclosure. The thermal stack 100f includes the heat generating component 183, a thermal interface material 173, and a heat sink 109. The heat sink 109 is essentially the same or similar to the corresponding components described herein with respect to FIG. 1A.

In addition, the thermal stack 100f includes the impact absorbent material 133f that is part of, or otherwise embedded or included, in the structure of the heat generating component. In this respect, the impact absorbent material 133f may comprise a woven fabric 136 (FIG. 1B) constructed of Kevlar^{™} or other material as described above with respect to the impact absorbent material 133a.

The thermal interface material 173 may comprise, for example, a semi-solid such as a thermal gel or a thermal grease. Alternatively, the thermal interface material 173 may comprise a thermal gap filler pad, a dielectric pad, thermal tapes, phase change materials, or other materials.

The inclusion of the impact absorbent material 133f in the thermal stack 100f provides for the containment of debris that might be launched by an arcing event or other failure in the heat generating component 183. Specifically, given the position of the impact absorbent material 133f relative to the heat generating component 183, the kinetic energy of such debris is absorbed. Given that the impact absorbent material 133f is positioned within the heat generating component 183 or is a part of the heat generating component 183, the containment of ejected debris occurs potentially closer to the source of the arcing event or other failure in the heat generating component 183.

Referring next to FIG. 7, shown is an example of an interwoven fabric 190 that comprises an interweave of the impact absorbent material 133g and some other material 193. The impact absorbent material 133g may comprise, for example, Kevlar^{™} or other impact absorbent material. The material 193 may comprise, for example, graphite or another material. The material 193 may be specified to enhance heat transfer through the interwoven fabric 190. For example, the material 193 may be constructed from metal or material that exhibits high heat conductivity. The interwoven fabric 190 is an example of a woven fabric as that term is used herein.

The ratio of threads of other elements of the impact absorbent material 133g and the other material 193 may be varied based on a tradeoff. Specifically, where more impact absorbent protection is used, more threads of impact absorbent material 133g may be included and vice versa. Also, the density of the threads of material 193 in the interwoven fabric 190 may depend upon the purpose of such material 193. For example, the material 193 may provide for greater heat transfer through the interwoven fabric 190 relative to the heat conductivity of the impact absorbent material 133g. Alternatively, the material 193 may be employed to detect intrusion through the interwoven fabric 190 by debris from an arcing event, an arcing event itself, or other failure. In this respect, the material 193 may comprise a weave of conductive material that detects discontinuity, change in capacitance, or other electrical change. It is understood that the impact absorbent material 133a-g described herein with reference to prior figures may comprise an interwoven fabric 190 that includes impact absorbent material 133g and other material 193.

In addition, it is understood that although the various examples describe a specific position of the impact absorbent material 133a-g in a given thermal stack 100a-f, it is understood that two or more of various examples may be combined. For example, the impact absorbent material 133a-g in the heat generating component 103, a thermal interface material 173, and a vapor chamber 106a-d may all be included in the same thermal stack 100a-f.

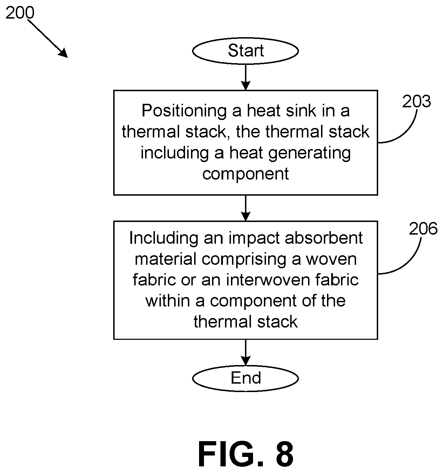

With reference next to FIG. 8, shown is a flowchart of a method 200 for cooling a heat generating component 103 (FIG. 1A) implemented in accordance with an example of the present disclosure. The method 200 begins with box 203 by positioning a heat sink 109 in a thermal stack 100a-f, the thermal stack 100a-f including the heat generating component 103. Then, in box 206, the method 200 further comprises including an impact absorbent material 133a-f comprising a woven fabric 136 (FIG. 1B) or an interwoven fabric 190 (FIG. 7) within a component of the respective thermal stack 100a-f.

In addition to the foregoing, the various approaches of the present disclosure include, but are not limited to, the approaches set forth in the following clauses.
1. A thermal stack comprising at least one vapor chamber positioned within the thermal stack including a heat generating component, a heat sink positioned adjacent to the at least one vapor chamber, and an impact absorbent material positioned within the thermal stack.
2. The thermal stack as set forth in any preceding clause, wherein the impact absorbent material further comprises a woven fabric constructed of Kevlar^{™}.
2-1. The thermal stack as set forth in any preceding clause, wherein the impact absorbent material further comprises a woven fabric constructed from at least one material comprising KevlarTM.
3. The thermal stack as set forth in any preceding clause, wherein the impact absorbent material is positioned within an internal chamber of the at least one vapor chamber.
4. The thermal stack as set forth in any preceding clause, further comprising the at least one vapor chamber being formed in a C-shape forming a gap; and the impact absorbent material is positioned in the gap.
4-1. The thermal stack as set forth in any preceding clause, further comprising the at least one vapor chamber being formed in a C-shape to define a gap, wherein the impact absorbent material is positioned in the gap.
5. The thermal stack as set forth in any preceding clause, wherein the at least one vapor chamber further comprises a first vapor chamber and a second vapor chamber, the thermal stack further comprising the impact absorbent material positioned between the first vapor chamber and the second vapor chamber.
6. The thermal stack as set forth in any preceding clause, further comprising the first vapor chamber including a side having at least one raised portion, and the impact absorbent material positioned in a pocket between the first vapor chamber and the second vapor chamber, the at least one raised portion at least partly defining the pocket.
7. The thermal stack as set forth in any preceding clause, wherein the impact absorbent material further comprises a plurality of sheets of woven fabric constructed at least in part from Kevlar^{™}, the thermal stack further comprising the sheets of woven fabric being offset with respect to each other.
8. The thermal stack as set forth in any preceding clause, wherein the impact absorbent material is included or disposed in a structure of the heat generating component.
9. The thermal stack as set forth in any preceding clause, wherein the impact absorbent material further comprises an interwoven fabric of Kevlar^{™} and another material.
10. A thermal stack, comprising a heat sink positioned in the thermal stack, the thermal stack including a heat generating component, a thermal interface material disposed between the heat sink and the heat generating component, and an impact absorbent material positioned within the thermal stack.
11. The thermal stack as set forth in any preceding clause, wherein the impact absorbent material further comprises a woven fabric.
12. The thermal stack as set forth in any preceding clause, wherein the woven fabric comprises Kevlar^{™}.
13. The thermal stack as set forth in any preceding clause, wherein the woven fabric further comprises an interwoven fabric of Kevlar^{™} and another material.
14. The thermal stack as set forth in any preceding clause, wherein the impact absorbent material is positioned within the thermal interface material.
15. The thermal stack as set forth in any preceding clause, wherein the thermal interface material further comprises a semi-solid, and the woven fabric is wetted through with the thermal interface material.
16. The thermal stack as set forth in any preceding clause, wherein the woven fabric is suspended in the semi-solid.
17. The thermal stack as set forth in any preceding clause, wherein the thermal interface material is embodied as a thermal pad, and the impact absorbent material further comprises a woven fabric, where the woven fabric is embedded in the thermal pad.
17-1. The thermal stack as set forth in any preceding clause, wherein the thermal interface material comprises a thermal pad, and the impact absorbent material further comprises a woven fabric, where the woven fabric is embedded in the thermal pad.
18. The thermal stack as set forth in any preceding clause, wherein the thermal interface material is embodied in a phase change material, and the impact absorbent material further comprises a woven fabric, where the woven fabric is embedded in the phase change material.
18-1. The thermal stack as set forth in any preceding clause, wherein the thermal interface material comprises a phase change material, and the impact absorbent material further comprises a woven fabric, where the woven fabric is embedded in the phase change material.
19. The thermal stack as set forth in any preceding clause, wherein the impact absorbent material further comprises a woven fabric, where the woven fabric is included as part of the heat generating component.
20. A method for cooling a heat generating component, comprising positioning a heat sink in a thermal stack, the thermal stack including the heat generating component; and including an impact absorbent material comprising a woven fabric within a component of the thermal stack.

Disjunctive language such as the phrase "at least one of X, Y, or Z," unless specifically stated otherwise, is otherwise understood with the context as used in general to present that an item, term, etc., may be either X, Y, or Z, or any combination thereof (e.g., X, Y, and/or Z). Thus, such disjunctive language is not generally intended to, and should not, imply that certain embodiments require at least one of X, at least one of Y, or at least one of Z to each be present.

It should be emphasized that the above-described embodiments of the present disclosure are merely possible examples of implementations set forth for a clear understanding of the principles of the disclosure. Many variations and modifications may be made to the above-described embodiment(s) without departing substantially from the spirit and principles of the disclosure. All such modifications and variations are intended to be included herein within the scope of this disclosure and protected by the following claims.

## Claims

1. A thermal stack (100a-f), comprising:
at least one vapor chamber (106a-d) positioned within the thermal stack (100a-f) including a heat generating component (103);
a heat sink (109) positioned adjacent to the at least one vapor chamber (106a-d); and
an impact absorbent material (133a-f) positioned within the thermal stack (100a-f).

2. The thermal stack (100a-f) of claim 1, wherein the impact absorbent material (133a-f) further comprises a woven fabric (136) constructed of KevlarTM.

3. The thermal stack (100a-f) of any preceding claim, wherein the impact absorbent material (133a-f) is positioned within an internal chamber (113a-d) of the at least one vapor chamber (106a-d).

4. The thermal stack (100a-f) of any preceding claim, further comprising the at least one vapor chamber (106a-d) being formed in a C-shape to define a gap (149a), wherein the impact absorbent material (133a-f) is positioned in the gap (149a).

5. The thermal stack (100a-f) of any preceding claim, wherein the at least one vapor chamber (106a-d) further comprises a first vapor chamber (106ca) and a second vapor chamber (106cb), the thermal stack (100a-f) further comprising the impact absorbent material (133a-f) positioned between the first vapor chamber (106ca) and the second vapor chamber (106cb).

6. The thermal stack (100a-f) of claim 5, further comprising:
the first vapor chamber (106ca) including a side having at least one raised portion (153); and
the impact absorbent material (133a-f) positioned in a pocket (159) between the first vapor chamber (106ca) and the second vapor chamber (106cb), the at least one raised portion (153) at least partly defining the pocket (159).

7. The thermal stack (100a-f) of claim 5 or 6, wherein the impact absorbent material (133a-f) further comprises a plurality of sheets of woven fabric (136) constructed at least in part from KevlarTM, the thermal stack (100a-f) further comprising the plurality of sheets of woven fabric (136) being offset with respect to each other.

8. The thermal stack (100a-f) of any preceding claim, wherein the impact absorbent material (133a-f) further comprises an interwoven fabric (190) of KevlarTM and another material.

9. A thermal stack (100a-f), comprising:
a heat sink (109) positioned in the thermal stack (100a-f), the thermal stack (100a-f) including a heat generating component (103);
a thermal interface material (173) disposed between the heat sink (109) and the heat generating component (103); and
an impact absorbent material (133a-f) positioned within the thermal stack (100a-f).

10. The thermal stack (100a-f) of claim 9, wherein the impact absorbent material (133a-f) further comprises a woven fabric (136).

11. The thermal stack (100a-f) of claim 10, wherein the woven fabric (136) comprises KevlarTM.

12. The thermal stack (100a-f) of claim 10 or 11, wherein the impact absorbent material (133a-f) is positioned within the thermal interface material (173).

13. The thermal stack (100a-f) of any of claims 9 to 12, wherein the thermal interface material (173) comprises a thermal pad, and the impact absorbent material (133a-f) further comprises a woven fabric (136), where the woven fabric (136) is embedded in the thermal pad.

14. The thermal stack (100a-f) of any of claims 9 to 13, wherein the thermal interface material (173) comprises a phase change material, and the impact absorbent material (133a-f) further comprises a woven fabric (136), where the woven fabric (136) is embedded in the phase change material.

15. The thermal stack (100a-f) of any of claims 9 to 14, wherein the impact absorbent material (133a-f) further comprises a woven fabric (136), where the woven fabric (136) is included as part of the heat generating component (103).
